Europäisches Patentamt

European Patent Office

Office européen des brevets

(19)

(11) Veröffentlichungsnummer: **0 107 073**
**B1**

(12) **EUROPÄISCHE PATENTSCHRIFT**

(45) Veröffentlichungstag der Patentschrift:
09.08.89

(21) Anmeldenummer: 83109568.2

(22) Anmeldetag: 26.09.83

(51) Int. Cl.⁴: **H 04 N   3/15,** H 01 L 27/14

(54) Zweidimensionaler Halbleiter-Bildsensor mit einer Anordnung zur Reduzierung des Überstrahlens.

(30) Priorität: 29.09.82 DE 3236073

(43) Veröffentlichungstag der Anmeldung:
02.05.84 Patentblatt 84/18

(45) Bekanntmachung des Hinweises auf die Patenterteilung: 09.08.89 Patentblatt 89/32

(84) Benannte Vertragsstaaten:
AT BE CH DE FR GB IT LI LU NL SE

(56) Entgegenhaltungen:
EP--A-- 0 046 396
JAPAN ELECTRONIC ENGINEERING, Nr. 40, März
1970, Seiten 37-40; TAKAO ANDO: "Image pickup IC"
IEEE JOURNAL OF SOLID-STATE CIRCUITS, Band
SC-9, Nr. 1, Februar 1974, Seiten 1-13; M.H.WHITE et
al.: "Characterization of surface channel CCD image
arrays at low light levels"
THE RADIO AND ELECTRONIC ENGINEER, Band 49,
Nr. 10, Oktober 1979, Seiten 493-498, Institution of
Electronic and Radio Engineers; J.D.E.BEYNON:
"Optical self-scanned arrays"

## Beschreibung

Die Erfindung bezieht sich auf einen zweidimensionalen Halbleiter-Bildsensor nach dem Oberbegriff des Patentanspruchs 1 und auf Verfahren zu seinem Betrieb.

Ein Halbleiter-Bildsensor dieser Art ist aus dem Datenblatt « Reticon Solid-State Image Sensor Arrays » der Reticon Corp., Mountain View, California, USA bekannt.

Bei Halbleiter-Bildsensoren stellt die Überbelichtung der Sensorelemente ein generelles Problem dar. Wenn in einem Sensorelement durch Überbelichtung mehr Ladungsträger freigesetzt werden, als aufgenommen werden könne, fließen die überschüssigen Ladungsträger in benachbarte Bildelemente oder auf die Spaltenleitungen ab. Diese Ausbreitung der Ladungsträger wird als Überstrahlen oder im englischen Sprachgebrauch als « Blooming » bezeichnet.

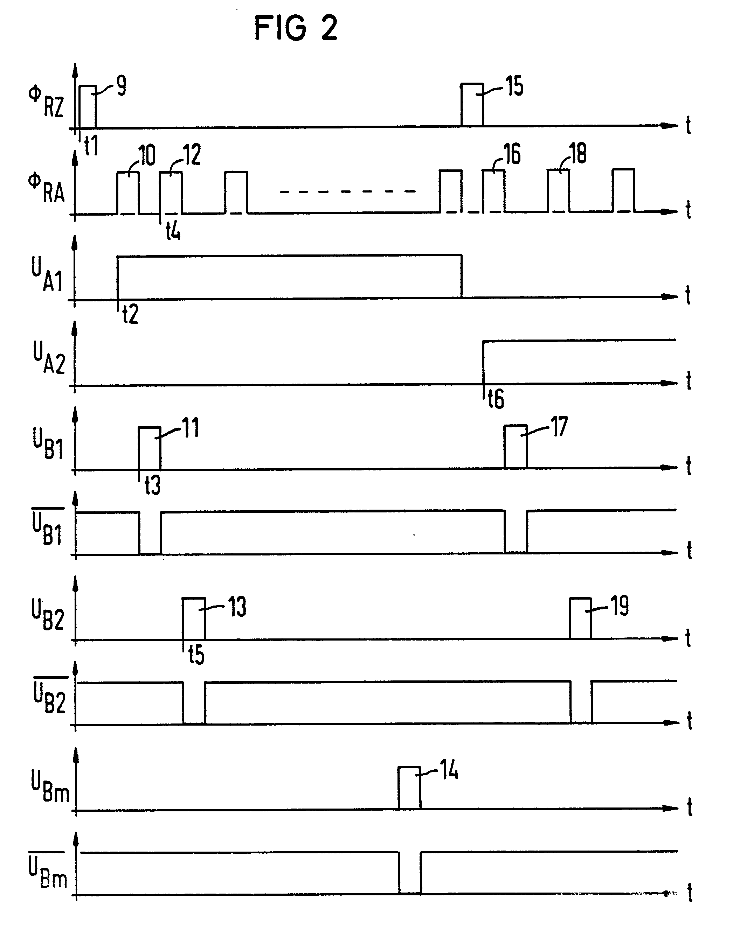

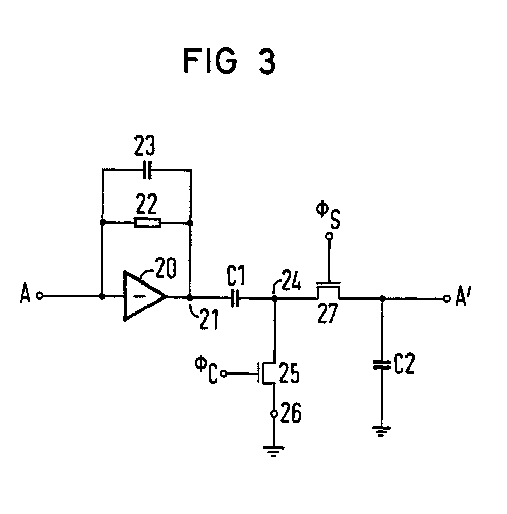

Die Verschaltung von Halbleiter-Bildsensoren zu einer zweidimensionalen Anordnung ist in der europäischen Patentanmeldung 0 046 396 und in der Veröffentlichung « Image Pick-up IC » von Takao Ando, Nippon Electric Co. Ltd. aus Japan Electronic Engineering, Nr. 40, March 1970, S. 37-40 wiedergegeben. Die europäische Patentanmeldung zeigt hierbei in Figur 3 eine Anordnung, in der jedes Sensorelement das Gate von einem Verstärkungstransistor ansteuert, wobei dieser in Serie zu einem Auswahltransistor geschaltet ist. Der Auswahltransistor selbst wiederum wird über einen Parallelausgang eines vertikalen Schieberegisters ausgewählt. Die Verstärkungstransistoren bieten hierbei eine erste Möglichkeit zu verhindern, daß überschüssige Ladungsträger in benachbarte Bildelemente oder auf die Spaltenleitungen abfließen. In der genannten Veröffentlichung von Takao Ando ist eine zweidimensionale Anordnung von Halbleitersensorelementen in der Figur 2 auf Seite 38 abgebildet. Jedes Sensorelement ist hierbei direkt mit zwei in Serie geschalteten Auswahltransistoren verbunden, wobei der erste Auswahltransistor über einen Ausgang eines horizontalen Schieberegisters und der zweite Auswahltransistor über den Ausgang eines vertikalen Schieberegisters verschaltet ist. Die beiden Auswahltransistoren erfüllen hierbei eine Doppelfunktion, zum einen dienen zur sie zur Vorladung des einzelnen Sensorelementes und im weiteren Verlauf zum Auslesen der elektrischen Ladung nach einer Belichtung der Halbleiter-Bildsensoren. Maßnahmen zur Begrenzung des « Blooming »-Effekts sind dieser Veröffentlichung nicht zu entnehmen.

Der Erfindung liegt die Aufgabe zugrunde, einen Halbleiter-Bildsensor der eingangs genannten Art mit einer flächensparenden Anordnung zur Reduzierung des Überstrahlens zu versehen. Das wird erfindungsgemäß durch eine Ausbildung des Bildsensors nach dem kennzeichnenden Teil des Patentanspruchs 1 erreicht.

Der mit der Erfindung erzielbare Vorteil besteht insbesondere darin, daß die vorgesehene Anordnung zur Reduzierung des Überstrahlens nur einen geringen zusätzlichen Platzbedarf hat und sehr wirkungsvoll arbeitet. Es kann beispielsweise eine Reduzierung des Überstrahlens auf etwa 1/500 erreicht werden.

Die Ansprüche 2 bis 4 sind auf bevorzugte Ausgestaltungen und Weiterbildungen der Erfindung gerichtet, während die Ansprüche 5 bis 7 vorteilhafte Verfahren zum Betrieb eines erfindungsgemäßen Halbleiter-Bildsensors betreffen. Ein nach Anspruch 3 ausgebildeter Bildsensor hat den zusätzlichen Vorteil, daß er weitgehend von Rausch- und Störspannungen befreite Sensorsignale abgibt.

Die Erfindung wird nachfolgend anhand der Zeichnung näher beschrieben. Dabei zeigt :

Fig. 1 das Prinzipschaltbild eines nach der Erfindung ausgebildeten, zweidimensionalen Halbleiter-Bildsensors,

Fig. 2 Spannungs-Zeit-Diagramme zur Erläuterung von Fig. 1,

Fig. 3 das Prinzipschaltbild einer in Serie zum Ausgang der Ausleseleitung angeordneten, differenzbildenden Stufe und

Fig. 4 Spannungs-Zeit-Diagramme zur Erläuterung der Wirkungsweise eines nach den Figuren 1 und 3 aufgebauten, erfindungsgemäßen Halbleiter-Bildsensors.

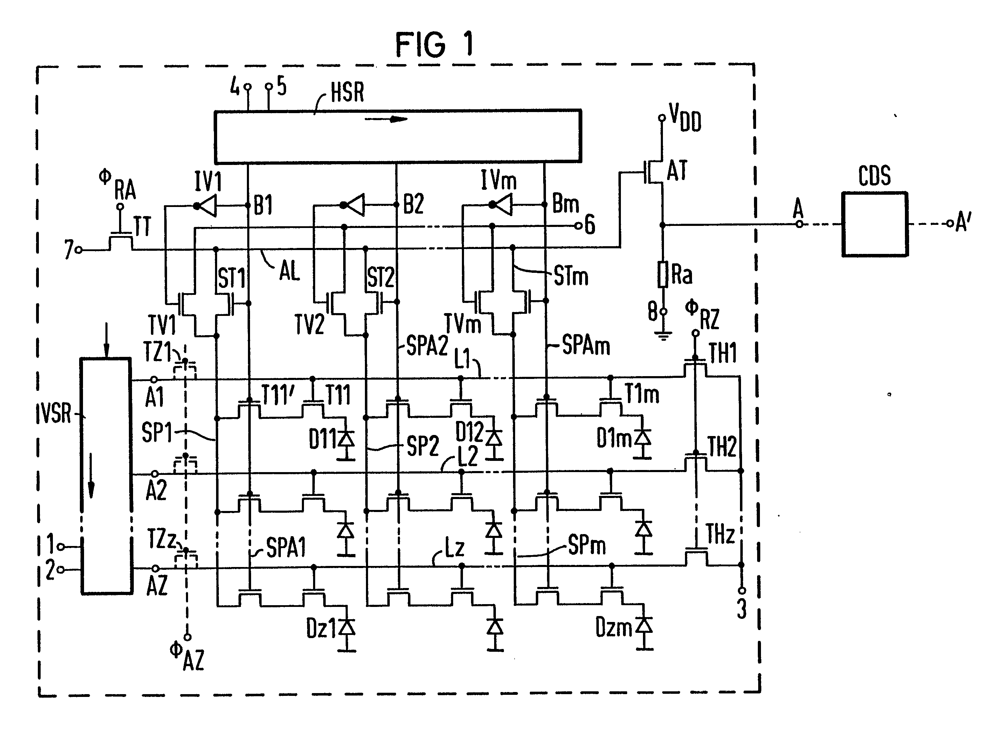

In Fig. 1 ist eine monolithisch ingetrierbare Schaltung mit einem zweidimensionalen Halbleiter-Bildsensor dargestellt, der aus Fotodioden bestehende, in Zeilen und Spalten angeordnete Sensorelemente aufweist. Die in der ersten Zeile liegenden Fotodioden sind mit $D11$ bis $D1m$ bezeichnet. In Serie zu diesen sind jeweils die Schaltstrecken von ersten Auswahltransistoren $T11$ bis $T1m$ vorgesehen, deren Gates mit einer gemeinsamen Zeilenleitung $L1$ verbunden sind. $L1$ ist an einen Parallelausgang $A1$ eines Vertikal-Schieberegisters $VSR$ geführt, welches Taktimpulseingänge 1 und 2 aufweist. Den weiteren Zeilen von Fotodioden und ersten Auswahltransistoren sind in analoger Weise Zeilenleitungen $L2$ bis $Lz$ zugeordnet, die an Parallelausgänge $A2$ bis $Az$ von $VSR$ gelegt sind. Jede der Zeilenleitungen $L1$ bis $Lz$ ist über einen Schalttransistor $TH1$ bis $THz$ mit einem Schaltungspunkt 3 verbunden, der mit einem Bezugspotential beschaltet ist. Die Gates von $TH1$ bis $THz$ haben einen gemeinsamen Anschluß, der mit einer Taktspannung $\emptyset_{RZ}$ belegt ist. Die unteren Anschlüsse aller Fotodioden $D11$ usw. sind jeweils mit dem Bezugspotential beschaltet.

In Serie zu den ersten Auswahltransistoren der Sensorelemente sind jeweils zweite Auswahltransistoren vorgesehen, wobei die in den Sensorelementen gebildeten, belichtungsabhängigen Sensorsignale jeweils über die Serienschaltung beider Auswahltransistoren auf eine sogenannte Spaltenleitung übertragen werden. In Fig. 1 ist beispielsweise das Sensorelement $D11$ über einen ersten Auswahltransistor $T11$ und einen zweiten Auswahltransistor T11' mit einer Spaltenleitung SP1 verbunden. Ebenso sind die übrigen Sensorelemente der ersten Spalte bis einschließlich Dz1 jeweils über die Serienschaltungen zweier Auswahltransistoren mit SP1 verbunden. Die Spaltenleitung SP1 ist ihrerseits über einen Spaltenauswahltransistor ST1 mit einer Ausleseleitung AL verbunden, die an das Gate eines Ausgangstransistors AT geführt ist. Das Gate des Spaltenauswahltransistors ST1 ist zusammen mit den Gates der zweiten Auswahltransistoren, die den Sensorelementen D11 bis Dz1 der ersten Spalte zugeordnet sind, über eine Spaltenauswahlleitung SPA1 an den ersten Parallelausgang B1 eines Horizontal-Schieberegisters HSR geschaltet, das mit Taktimpulseingängen 4 und 5 versehen ist.

In analoger Weise ist den Sensorelementen der zweiten Spalte eine mit der Ausleseleitung AL über einen Spaltenauswahltransistor ST2 verbundene Spaltenleitung SP2 zugeordnet, wobei das Gate von ST2 zusammen mit den Gates der zweiten Auswahltransistoren der Sensorelemente dieser Spalte über eine Spaltenauswahlleitung SPA2 mit dem zweiten Parallelausgang B2 von HSR verbunden ist. Schließlich sind auch die übrigen Spalten der Sensorelemente, z. B. D1m bis Dzm, über ihnen zugeordnete Spaltenleitungen, z. B. SPm, und Spaltenauswahltransistoren, z. B. STm, mit der Ausleseleitung AL verbunden, wobei die zugehörigen zweiten Auswahltransistoren und Spaltenauswahltransistoren, z. B. STm, jeweils über zugeordnete Spaltenauswahlleitungen, z. B. SPAm, von einem Parallelausgang z. B. Bm, von HSR angesteuert werden. Die Spaltenleitungen SP1 bis SPm sind über die Schaltstrecken von Transistoren TV1 bis TVm mit einem Schaltungspunkt 6 verbunden, der auf einem Referenzpotential $V_{ref}$ liegt. Die Gates von TV1 bis TVm sind mit den Ausgängen von Invertern IV1 bis IVm verbunden, deren Eingänge an B1 bis Bm liegen. Die Ausleseleitung AL ist über die Schaltstrecke eines Transistors TT mit einem Schaltungspunkt 7 verbunden, der vorzugsweise auf dem gleichen Referenzpotential liegt, wie der Schaltungspunkt 6. Das Gate von TT liegt dabei an einem mit einer Taktspannung $\varphi_{RA}$ beschalteten Anschluß.

Der Ausgangstransistor AT liegt mit seinem Drainanschluß an der Versorgungsspannung $V_{DD}$, während sein Sourceanschluß über ein Lastelement Ra an einen Schaltungspunkt 8 geführt ist, der mit dem Bezugspotential beschaltet ist. Der Sourceanschluß von AT, der den Ausgang der Ausleseleitung AL darstellt, bildet gleichzeitig den Sensorausgang A.

Die Schieberegister VSR und HSR sind vorzugsweise als zweiphasige, dynamische, rückgekoppelte Schieberegister ausgebildet. In VSR wird eine logische « 1 » in Abhängigkeit von zwei über die Eingänge 1, 2 zugeführten Taktimpulsspannungen von Stufe zu Stufe übertragen. Die Übertragungsrichtung ist durch einen Pfeil gekennzeichnet. Es wird davon ausgegangen, daß zu einem bestimmten Zeitpunkt t1 eine logische « 1 » am Ausgang A1 der ersten Stufe von VSR anliegt, wobei die an A1 auftretende Spannung mit $U_{A1}$ bezeichnet wird. Nach dem Auftreten der nächstfolgenden Taktimpulse an den Eingängen 1 und 2 hat sich dann die « 1 » soweit in Pfeilrichtung verschoben, daß sie am zweiten Parallelausgang A2 als Spannung $U_{A2}$ anliegt. Dieses Weiterschalten der « 1 » setzt sich solange fort, bis der Ausgang $A_z$ der letzten Stufe mit einer Spannung belegt ist. Die nächstfolgenden Taktimpulse an 1 und 2 bringen dann die « 1 » wieder an den Ausgang A1 der ersten Stufe. Die Ausgänge der jeweils nicht mit der « 1 » belegten Stufen liegen auf dem Potential « 0 ».

Das Schieberegister HSR wird mittels der den Eingängen 5 und 6 zugeführten Taktimpulsspannungen in gleicher Weise betrieben. Dabei verschiebt sich eine logische « 1 » im Takt der Taktimpulsspannungen in Pfeilrichtung, was zu Spannungen $U_{B1}$, $U_{B2}$ usw. an den Parallelausgängen B1, B2 usw. führt.

Zum Zeitpunkt t1 werden die Zeilenleitungen mittels des Taktimpulses 9 von $\varphi_{RZ}$ auf das Bezugspotential des Punktes 3 zurückgesetzt. Durch das Auftreten der Spannung $U_{A1}$ zum Zeitpunkt t2 wird die erste Zeile von Sensorelementen, d. h. D11 bis D1m, für das Auslesen ausgewählt, indem ihre ersten Auswahltransistoren T11 bis T1m über L1 leitend geschaltet werden. Gleichzeitig wird die Ausleseleitung mittels des Taktimpulses 10 der Spannung $\varphi_{RA}$ auf das Referenzpotential des Punktes 7 zurückgesetzt. Zum Zeitpunkt t3 tritt eine Spannung $U_{B1}$ am Parallelausgang B1 von HSR auf, gleichzeitig damit wird die vorher am Ausgang von IV1 vorhanden gewessene Spannung $U_{B1}$ (Fig.2) abgeschaltet. Durch den Impuls 11 von $U_{B1}$ wird die Spaltenauswahlleitung SPA1 ausgewählt, wobei der Transistor ST1 und die zweiten Auswahltransistoren T11' usw. der ersten Spalte leitend geschaltet werden. Aber nur das im Schnittpunkt der ausgewählten Leitungen L1 und SPA1 liegende Sensorelement D11 wird nun ausgelesen. Dabei wird das in D11 gespeicherte, belichtungsabhängige Sensorsignal über T11, T11', SP1, ST1, AL und AT zum Ausgang A übertragen. Wesentlich ist hierbei, daß diese Übertragung nur während des Auftretens des Impulses 11 von $U_{B1}$ erfolgt, wogegen vor und nach dem Auftreten von $U_{B1}$ die Spannung $U_{B1}$ den Transistor TV1 leitend schaltet, so daß die Spaltenleitung SP1 auf dem Potential $V_{ref}$ liegt, durch das etwige überschüssige Ladungsträger, die aus den Sensorelementen D11 bis Dz1 infolge des geschilderten Überstrahlens auf SP1 gelangt sind, über TV1 abgeleitet werden. Weiterhin sind auch die übrigen Spaltenleitungen SP2 bis SPm jeweils in den Zeitabschnitten, in denen sie nicht zur Übertragung von Sensorsignalen aus den ihnen zugeordneten Spalten des Sensors dienen, über die Transistoren TV2 bis TVm stets mit dem Referenzpotential $V_{ref}$ des Schaltungspunktes 6 verbunden. Daher werden auch auf diesen Spaltenleitungen auftretende, überschüssige Ladungsträger weitgehend entfernt.

Fig. 2 läßt erkennen, daß nach dem Auslesen des Sensorsignals aus D11, d. h. zum Zeitpunkt t4, die Ausleseleitung AL mittels des Impulses 12 von $\varphi_{RA}$ über TT zurückgesetzt wird, worauf zum Zeitpunkt t5 ein Impuls 13 von $U_{B2}$ die zweite Spaltenauswahlleitung SPA 2 auswählt, was eine Übertragung des Sensorsignals aus D12 an den Ausgang A in einer zu dem bereits beschriebenen Auslesevorgang analogen Weise bewirkt. Weitere Auslesevorgänge schließen sich an, wobei der Impuls 14 von $U_{Bm}$ das Auslesen des Sensorsignals aus dem Element D1m betrifft. Danach wird $U_{A1}$ abgeschaltet, worauf ein Impuls 15 von $\varphi_{RZ}$ ein Rücksetzen der Zeilenleitungen L1 bis Lz bewirkt. Im Anschluß daran läuft nach dem Auftreten von $U_{A2}$ zum Zeitpunkt t6 ein sequentieller Auslesevorgang für die Sensorelemente der zweiten Sensorzeile an, der durch die Impulse 16 bis 19 in derselben Weise kontrolliert wird, wie oben anhand der Impulse 10 bis 13 erläutert worden ist. Nach dem Auslesen sämtlicher Sensorelemente des Bildsensors folgen weitere komplette Auslesevorgänge in periodischer Folge.

Mit der Anordnung nach Fig. 1 wird das Überstrahlen auf

$$1/m/1-1/m = 1/m$$

verringert, wenn m die Anzahl der Sensorelemente in einer Zeile bedeutet.

Fig. 3 zeigt das Schaltschema einer zweckmäßigen Ausführungsform einer differenzbildenden Stufe ODS, die nach einer Weiterbildung der Erfindung dem Sensorausgang A nachgeschaltet wird. In diesem Fall bildet A' den eigentlichen Sensorausgang. Zusätzlich werden zwischen die Zeilenleitungen L1 bis Lz und die Ausgänge A1 bis Az Zeilenauswahltransistoren TZ1 bis TZz geschaltet, deren Gates über einen gemeinsamen Anschluß mit einer Taktimpulsspannung $\varphi_{AZ}$ beschaltet sind.

Die Stufe CDS ist nach Fig. 3 so aufgebaut, daß man vom Eingang A zu einem Vorverstärker 20 gelangt, dessen Ausgang 21 über die Parallelschaltung eines Widerstandes 22 und einer Kapazität 23 an den Eingang A rückgekoppelt ist. In Serie zum Ausgang 21 liegt eine Kapazität C1, deren vom Verstärkerausgang abgewandter Anschluß 24 über einen Schalttransistor 25 mit einem auf Bezugspotential liegenden Schaltungspunkt 26 verbunden ist. Das Gate des Schalttransistors 25 ist mit einer Taktspannung $\varphi_c$ beschaltet. Der Anschluß 24 ist über die Schaltstrecke eines Schalttransistors 27 mit dem ersten Anschluß einer Kapazität C2 beschaltet, deren zweiter Anschluß auf Bezugspotential liegt. Der erste Anschluß von C2 bildet den Ausgang A' der Stufe CDS und damit den Ausgang des Bildsensors. Die Schaltungsteile 27 und C2 stellen eine Abtast- und Haltestufe dar. Dabei ist das Gate von 27 mit einer Taktspannung $\varphi_s$ beschaltet.

Eine differenzbildende Stufe der vorstehend beschriebenen Art ist z. B. dem Buch von P. G. Jespers u. a. « Solid State Imaging » aus der Reihe « NATO Advanced Study Institutes », Series E ; No. 16, erschienen 1976 im Verlag Noordhoff International Publishing, Leyden, auf den Seiten 535 bis 559, insb. Fig. 9, zu entnehmen.

Eine ähnlich aufgebaute Stufe ist in dem IEEE Journal of Solid State Circuits, Vol. SC-9, No. 1, Februar 1974, auf den Seiten 1 bis 13, vgl. insb. Fig. 5, beschrieben.

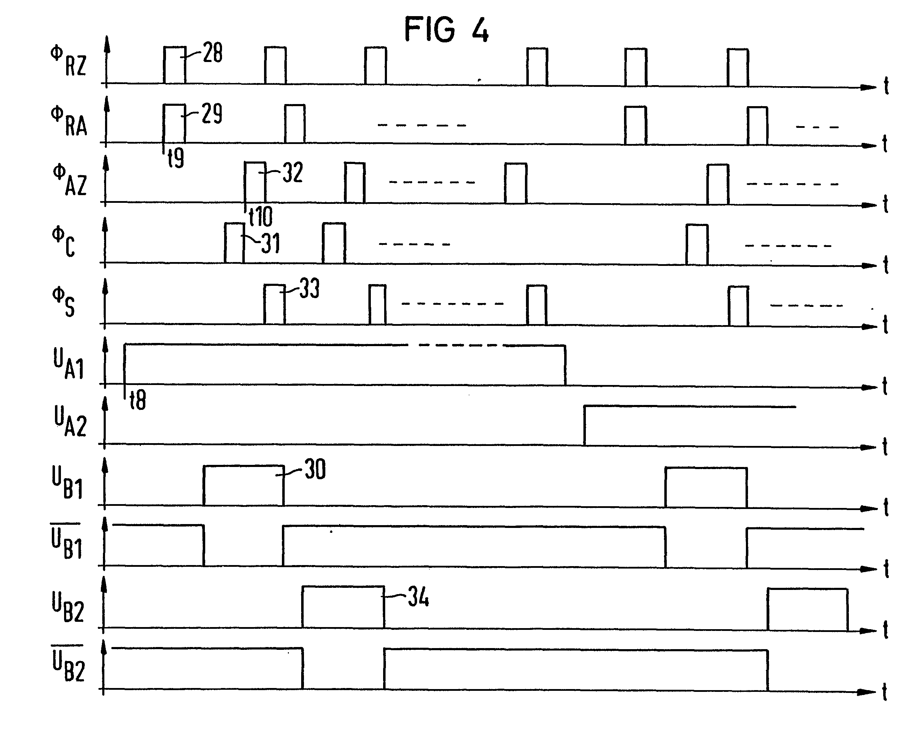

Der Auslesevorgang bei einem durch die Zeilenauswahltransistoren TZ1...TZz und die Stufe CDS ergänzten Bildsensor wird anhand der Fig. 4 erläutert. Zu einem Zeitpunkt t8 tritt eine Spannung $U_{A1}$ an $A_1$ auf. Dadurch wird die erste Zeile von Sensorelementen, d. h. D11 bis D1m, für das Auslesen ausgewählt. Der Zeilenauswahltransistor TZ1 bleibt aber noch gesperrt. Zum Zeitpunkt t9 werden die Zeilenleitungen L1 bis Lz durch den Taktimpuls 28 von $\varphi_{RZ}$ auf das Bezugspotential des Punktes 3 zurückgesetzt, während LA durch den Impuls 29 von $\varphi_{RA}$ auf das Referenzpotential des Punktes 7 zurückgesetzt wird. Beim Auftreten des Impulses 30 von $U_{B1}$ wird SPA1 ausgewählt, wobei ST1 und die zweiten Auswahltransistoren T11' usw. der ersten Sensorspalte leitend geschaltet werden. Über ST1 wird SP1 mit AL verbunden. Der Momentanwert des Rauschens auf SP1 und auf AL sowie die durch das Schalten von T11' usw. und ST1 erfolgten Störspannungseinkopplungen werden durch den Impuls 31 von $\varphi_c$, der den Schalttransistor 25 (Fig. 3) leitend schaltet, mit negativem Vorzeichen in C1 gespeichert. Zum Zeitpunkt t10 werden dann alle ersten Auswahltransistoren T11...T1m der ausgewählten Zeile mittels des Impulses 32 von $\varphi_{AZ}$ leitend geschaltet. Damit wird das Sensorelement, das im Schnittpunkt der ausgewählten Leitungen L1 und SPA1 liegt, ausgelesen. Das ausgelesene Sensorsignal, das ebenfalls mit dem Momentanwert des Rauschens auf SP1 und AL sowie mit den gennanten Störspannungseinkopplungen behaftet ist, wird nach dem Sperren des Schalttransistors 25 (Fig. 3) dem zuvor in C1 gespeicherten Signal mit positivem Vorzeichen überlagert, so daß sich am Schaltungspunkt 24 das von den genannten Rauschspannungen und Störspannungseinkopplungen befreite Sensorsignal als Differenz der beiden nacheinander ausgelesenen Signale ergibt. Durch den Impuls 33 von $\varphi_S$ wird der so erhaltene Signalwert über den Transistor 27 auf die Kapazität C2 übertragen und dort gespeichert, so daß er bei A' abgreifbar ist.

Nach dem Auftreten des Impulses 34 von $U_{B2}$ folgen ein gleichartiger Auslesevorgang für das Sensorelement D12 und analoge weitere Auslesevorgänge für die übrigen Sensorelemente der ersten Zeile und der weiteren Zeilen. Der komplette Auslesevorgang des gesamten Bildsensors wiederholt sich periodisch. Die Spannungen $U_{B1}$, $U_{B2}$ usw. gewährleisten in der bereits beschriebenen Weise eine erhebliche Reduzierung des Überstrahlens.

Der erste und zweite Auswahltransistor, z. B. T11 und T11', eines Sensorelements, z. B. D11, können platzsparend zu einem Dual-Gate-Transistor zusammengefaßt werden. Dabei kann das Gate von T11' aus einer ersten Schicht polykristallinen Siliziums gebildet sein und das Gate von T11 aus einer zweiten solchen Schicht.

## Patentansprüche

1. Zweidimensionaler Halbleiter-Bildsensor mit auf einem dotierten Halbleiterkörper in Zeilen und Spalten angeordneten Sensorelementen, bei dem Zeilenleitungen, die über zugeordnete Parallelausgänge eines Vertikal-Schieberegisters auswählbar sind, zur Ansteuerung von ersten Auswahltransistoren der Sensorelemente dienen, bei dem zweite Auswahltransistoren jeweils in Serie zu den ersten Auswahltransistoren angeordnet sind, wobei Spaltenleitungen über weitere Schalter (TV1...TVm) mit einem Referenzpotential ($V_{ref}$) beschaltet sind, und bei dem die Spaltenleitungen über Schalter, die von Parallelausgängen eines horizontalen Schieberegisters ansteuerbar sind, nacheinander mit einer Ausleseleitung verbindbar sind, die einen Ausgang zum sequentiellen Auslesen der Sensorsignale aufweist, dadurch gekennzeichnet, daß die Parallelausgänge des Horizontal-Schieberegisters zusätzlich zur spaltenweisen Ansteuerung von den zweiten Auswahltransistoren der Sensorelemente dienen, daß über die ersten Auswahltransistoren die in den Sensorelementen gebildeten, belichtungsabhängigen Sensorsignale auf Spaltenleitungen übertragen werden, und daß die von den Parallelausgängen (B1...Bm) des horizontalen Schieberegisters (HSR) ansteuerbaren Schalter (ST1...STm) invers zu den weiteren Schaltern (TV1...TVm) ansteuerbar sind.

2. Zweidimensionaler Halbleiter-Bildsensor nach Anspruch 1, dadurch gekennzeichnet, daß die Zeilenleitungen (L1...Lz) über erste Schalttransistoren (TH1...THz) mit einem ersten Schaltungspunkt (3) verbunden sind, der auf Bezugspotential liegt, daß die Spaltenleitungen (SP1...SPm) über zweite Schalttransistoren (TV1...TVm) mit einem zweiten Schaltungspunkt (6) verbunden sind, der auf einen Referenzpotential ($V_{ref}$) liegt, und daß die Ausleseleitung (AL) über einen dritten Schalttransistor (TT) mit einem dritten Schaltungspunkt (7) verbunden ist, der vorzugsweise ebenfalls mit diesem Referenzpotential ($V_{ref}$) beschaltet ist.

3. Zweidimensionaler Halbleiter-Bildsensor nach Anspruch 1 oder 2, dadurch gekennzeichnet, daß die Zeilenleitungen (L1...Lz) über Zeilenauswahltransistoren (ZT1...ZTz) an die Parallelausgänge (A1...Az) des vertikalen Schieberegisters (VSR) geschaltet sind und daß in Serie zum Ausgang (A) der Ausleseleitung (AL) eine differenzbildende Stufe (CDS) vorgesehen ist, die aus zwei unmittelbar nacheinander ausgelesenen Signalen ein Differenzsignal ableitet.

4. Zweidimensionaler Halbleiter-Bildsensor nach Anspruch 3, dadurch gekennzeichnet, daß die differenzbildende Stufe einen eingangsseitigen Vorverstärker (20), eine in Serie zu dessen Ausgang (21) liegende Kapazität (C1), einen Schalter (25), der den vom Verstärkerausgang (21) abgewandten Anschluß (24) der Kapazität (C1) mit einem auf Bezugspotential liegenden Schaltungspunkt (26) verbindet, und eine ausgangsseitige Abtast- und Haltestufe (27, C2) aufweist.

5. Verfahren zum Betrieb eines Halbleiter-Bildsensors nach Anspruch 1, wobei die Spaltenauswahlleitung (SPA1) der ersten Sensorspalte über einen Parallelausgang (B1) des horizontalen Schieberegisters (HSR) mit einer Spannung beaufschlagt wird, die von den zugehörigen Spaltenauswahltransistoren (ST1) dieser Sensorspalte leitend schaltet, und daß im weiteren Verlauf des Verfahrens das Sensorsignal des ersten Sensorelements (D11) der Sensorzeile über den leitenden Spaltenauswahltransistor (ST1) auf den Sensorausgang (A) übertragen wird, dadurch gekennzeichnet, daß die Zeilenleitung (L1) einer auszulesenden Sensorzeile über einen Parallelausgang (A1) des vertikalen Schieberegisters (VSR) ausgewählt wird, wobei die ersten Auswahltransistoren (T11...) der Sensorzeile leitend geschaltet werden, daß die Spaltenauswahlleitung (SPA1) der ersten Sensorspalte über einen Parallelausgang (B1) des horizontalen Schieberegisters (HSR) mit einer Spannung beaufschlagt wird, die die zweiten Auswahltransistoren (T11') und den Spaltenauswahltransistor (ST1) dieser Sensorspalte leitend schaltet, daß lediglich für die Dauer des leitenden Zustandes des Spaltenauswahltransistors (ST1) der sonst stets durchgeschaltete, mit der Spaltenleitung (SP1) der ersten Spalte verbundene, weitere Schalter (TV1) öffnet, daß das Sensorsignal des ersten Sensorelements (D11) auf den Sensorausgang (A) übertragen wird und daß dieser Auslesevorgang sequentiell für alle Sensorelemente der auszulesenden Sensorzeile und sodann in analoger Weise für die weiteren Sensorzeilen durchgeführt wird.

6. Verfahren zum Betrieb eines Halbleiter-Bildsensors nach Anspruch 3, dadurch gekennzeichnet, daß die Zeilenleitung (L1) einer auszulesenden Sensorzeile über einen Parallelausgang (A1) des vertikalen Schieberegisters (VSR) ausgewählt wird, wobei jedoch der zugeordnete Zeilenauswahltransistor (TZ1) noch gesperrt bleibt, daß die Spaltenauswahlleitung (SPA1) der ersten Sensorspalte über einen Parallelausgang (B1) des horizontalen Schieberegisters (HSR) mit einer Spannung beaufschlagt wird, die den zugehörigen Spaltenauswahltransistor (ST1) und die zweiten Auswahltransistoren (T11') der Sensorelemente (D11) dieser Spalte leitend schaltet, daß lediglich für die Dauer des leitenden Zustands des Spaltenauswahltransistors (ST1) der sonst stets durchgeschaltete, mit der Spaltenleitung (SP1) der ersten Spalte verbundene, weitere Schalter öffnet, daß über den leitend geschalteten Spaltenauswahltransistor (ST1) die Rauschspannungsanteile auf der Spaltenleitung (SP1) und Ausleseleitung (AL) und durch die betätigten Schalttransistoren entstandene Störspannungseinkopplungen in der differenzbildenden Stufe (CDS) mit einem ersten Vorzeichen gespeichert werden, daß anschließend der Zeilenauswahltransistor (TZ1) der ausgewählten Zeilenleitung leitend geschaltet wird, so daß die ersten Auswahltransistoren (T11) der Sensorzeile leitend geschaltet werden, daß das Sensorsignal des ersten Sensorelements (D11) dieser Sensorzeile einschließlich der genannten Rauschspannungsanteile und Störspannungseinkopplungen in der differenzbildenden Stufe (CDS) dem zuvor gespeicherten Signal mit einem zweiten Vorzeichen überlagert wird, daß das entstehende Differenzsignal an den Sensorausgang (A') übertragen wird und daß dieser Auslesevorgang sequentiell für alle Sensorelemente der ausgewählten Sensorzeile und sodann in analoger Weise für die weiteren Sensorzeilen durchgeführt wird.

7. Verfahren nach einem der Ansprüche 5 oder 6, dadurch gekennzeichnet, daß vor dem Anlegen der am Parallelausgang (B1) des horizontalen Schieberegisters (HSR) auftretenden Spannung an die Spaltenauswahlleitung (SPA1) die Zeilenleitungen (L1...Lz) auf Bezugspotential (3) und die Ausleseleitung (AL) auf ein Referenzpotential zurückgesetzt werden.

## Claims

1. Two-dimensional semiconductor image sensor having sensor elements arranged in rows and columns on a doped semiconductor body, in which sensor row conductors, which can be selected via associated parallel outputs of a vertical shift register, serve to trigger first selection transistors of the sensor elements, in which sensor second selection transistors are in each case arranged in series with the first selection transistors, column conductors being connected to a reference potential ($V_{ref}$) via further switches (TV1...TVm), and in which sensor the column conductors can be connected in sequence to a read-out conductor, which has an output for sequentially reading out the sensor signals, via switches which can be triggered by parallel outputs of a horizontal shift register, characterised in that the parallel outputs of the horizontal shift register serve additionally to trigger columnwise the second selection transistors of the sensor elements, in that the exposure-dependent sensor signals formed in the sensor elements are transferred to column conductors via the first selection transistors, and in that the switches (ST1...STm) which can be triggered by the parallel outputs (B1...Bm) of the horizontal shift register (HSR) can be triggered inversely to the further switches (TV1...TVm).

2. Two-dimensional semiconductor image sensor according to Claim 1, characterised in that the row conductors (L1...Lz) are connected via first switching transistors (TH1...THz) to a first circuit point (3) which is at standard potential, in that the column conductors (SP1...SPm) are connected via second switching transistors (TV1...TVm) to a second circuit point (6) which is at a reference potential ($V_{ref}$), and in that the read-out conductor (AL) is connected via a third switching transistor (TT) to a third circuit point (7) which is preferably also connected to said reference potential ($V_{ref}$).

3. Two-dimensional semiconductor image sensor according to Claim 1 or 2, characterised in that the row conductors (L1...Lz) are connected to the parallel outputs (A1...Az) of the vertical shift register (VSR) via row selection transistors (ZT1...ZTz) and in that a difference-forming stage (CDS) which derives a difference signal from two signals read out immediately after each other is provided in series with the output (A) of the read-out conductor (AL).

4. Two-dimensional semiconductor image sensor according to Claim 3, characterised in that the difference-forming stage has an output-side amplifier (20), a capacitor (C1) situated in series with the output (21) thereof, a switch (25) which connects the terminal (24) of the capacitor (C1) facing away from the amplifier output (21) to a circuit point (26) at standard potential, and an output-side sampling and holding stage (27, C2).

5. Method for operating a semiconductor image sensor according to Claim 1 in which the column selection conductor (SPA1) of the first sensor column has applied to it, via a parallel output (B1) of the horizontal shift register (HSR), a voltage which switches the associated column selection transistor (ST1) of said sensor column to conduction, and in that, in the further course of the method, the sensor signal of the first sensor element (D11) of the sensor row is transferred to the sensor output (A) via the conducting column selection transistor (ST1), characterised in that the row conductor (L1) of a sensor row to be read out is selected via a parallel output (A1) of the vertical shift register (VSR), the first selection transistors (T11...) of the sensor row being switched to conduction, in that the column selection conductor (SPA1) of the first sensor column has applied to it, via a parallel output (B1) of the horizontal shift register (HSR), a voltage which switches the second selection transistors (T11') and the column selection transistor (ST1) of said sensor column to conduction, in that the further switch (TV1), which is otherwise always switched through and is connected to the column conductor (SP1) of the first column, opens only for the duration of the conducting state of the column selection transistor (ST1), in that the sensor signal of the first sensor element (D11) is transferred to the sensor output (A), and in that this read-out operation is carried out sequentially for all the sensor elements of the sensor row to be read out and then in an analagous manner for the further sensor rows.

6. Method for operating a semiconductor image sensor according to claim 3, characterised in that the row conductors (L1) of a sensor row to be read out is selected via a parallel output (A1) of the vertical shift register (VSR) but the associated row selection transistor (TZ1) still remains disabled, in that the column selection conductor (SPA1) of the first sensor column has applied to it, via a parallel output (B1) of the horizontal shift register (HSR), a voltage which switches the associated column selection transistor (ST1) and the second selection transistors (T11') of the sensor elements (D11) of said column to conduction, in that the further switch, which is otherwise always switched through and is connected to the column conductor (SP1) of the first column, opens only for the duration of the conducting state of the column selection transistor (ST1) in that the noise voltage components on the column conductor (SP1) and the read-out conductor (AL) and the interference voltage injections, produced by the actuated switching transistors, in the difference-forming stage (CDS) are stored with a first sign via the column selection transistor (ST1) switched to conduction, in that the row selection transistor (TZ1) of the selected row conductor is then switched to conduction, with the result first selection transistors (T11) of the sensor row are switched to conduction, in that the sensor signal of the first sensor element (D11) of said sensor row including the said noise voltage components and interference voltage injections in the difference-forming stage (CDS) is superimposed on the previously stored signal with a second sign, in that the difference signal produced is transferred to the sensor output (A'), and in that this read-out operation is carried out sequentially for all the sensor elements of the selected sensor row and then in an analagous manner for the further sensor rows.

7. Method according to one of Claims 5 or 6, characterised in that the row conductors (L1...Lz) are reset to standard potential (3) and the read-out conductor (AL) is reset to a reference potential before applying the voltage, produced at the parallel output (B1) of the horizontal shift register (HSR), to the column selection conductor (SPA1).

## Revendications

1. Capteur d'images bidimensionnel à semi-conducteurs, possédant des éléments capteurs disposés en lignes et colonnes sur un corps semiconducteur dopé, dans lequel des conducteurs de lignes, pouvant être sélectés à travers des sorties parallèles coordonnées d'un registre à décalage vertical, servent à attaquer des premiers transistors de sélection des éléments capteurs, dans lequel des seconds transistors de sélection sont disposés chacun en série avec les premiers transistors de sélection, avec connexion de conducteurs de colonnes à un potentiel de réfé-rence (Vref) à travers d'autres interrupteurs (TV1...TVm), et dans lequel les conducteurs de colonnes peuvent être reliés l'un après l'autre à un conducteur de lecture à travers des interrupteurs pouvant être commandés par des sorties parallèles d'un registre à décalage horizontal, le conducteur de lecture présentant une sortie pour la lecture séquentielle des signaux du capteur, caractérisé en ce que les sorties parallèles du registre à décalage horizontal servent, en plus, à l'attaque, colonne par colonne, des seconds transistors de sélection des éléments capteurs, que les signaux du capteur, formés dans les éléments capteurs et qui dépendent de l'éclairement, sont transmis à travers les premiers transistors de sélection à des conducteurs de colonnes et que les interrupteurs (ST1...STm), pouvant être commandés par les sorties parallèles (B1...Bm) du registre à décalage horizontal (HSR), peuvent être attaqués de façon inverse par rapport aux autres interrupteurs (TV1...TVm).

2. Capteur selon la revendication 1, caractérisé en ce que les conducteurs de lignes (L1...Lz) sont reliés à travers des premiers transistors de commutation (TH1...THz) à un premier point (3) du circuit qui se trouve au potentiel de base, que les conducteurs de colonnes (SP1...SPm) sont reliés à travers des seconds transistors de commutation (TV1...TVm) à un deuxième point (6) du circuit qui se trouve à un potentiel de référence (Vref) et que le conducteur de lecture (AL) est relié à travers un troisième transistor de commutation (TT) à un troisième point (7) du circuit auquel est de préférence appliqué également ce potentiel de référence (Vref).

3. Capteur selon la revendication 1 ou 2, caractérisé en ce que les conducteurs de lignes (L1...Lz) sont connectés à travers des transistors de sélection de lignes (ZT1...ZTz) aux sorties parallèles (A1...Az) du registre à décalage vertical (VSR) et qu'un étage de formation de différence (CDS) est prévu en série avec la sortie (A) du conducteur de lecture (AL) pour produire un signal de différence à partir de deux signaux lus immédiatement l'un à la suite de l'autre.

4. Capteur selon la revendication 3, caractérisé en ce que l'étage de formation de différence présente un préamplificateur (20) situé du côté de l'entrée, une capacité (C1) disposée en série avec la sortie (21) de ce préamplificateur, un interrupteur (25) qui relie la capacité (C1), par sa connexion (24) éloignée de la sortie (21) du préamplificateur, à un point (26) du circuit se trouvant au potentiel de base, de même que, du côté de la sortie, un étage d'échantillonnage et de maintien (27, C2).

5. Procédé pour la mise en œuvre d'un capteur d'images à semi-conducteurs selon la revendication 1, selon lequel le conducteur de sélection de colonne (SPA1) de la première colonne du capteur est alimenté, à travers une sortie parallèle (B1) du registre à décalage horizontal (HSR), avec une tension qui rend conducteur les transistors de sélection de colonnes (ST1) correspondants de cette colonne du capteur et selon lequel, dans la suite du processus, le signal de capteur du premier élément capteur (D11) de la ligne est transmis à travers le transistor de sélection de colonne (ST1), conducteur, à la sortie (A) du capteur, caractérisé en ce que le conducteur de ligne (L1) d'une ligne à lire du capteur, est sélecté à travers une sortie parallèle (A1) du registre à décalage vertical (VSR), ce qui rend conducteur les premiers transistors de sélection (T11...) de la ligne concernée du capteur, que le conducteur de sélection de colonne (SPA1) de la première colonne du capteur est alimenté, à travers une sortie parallèle (B1) du registre à décalage horizontal (HSR), avec une tension qui rend conducteur les seconds transistors de sélection (T11') et le transistor de sélection de colonne (ST1) de cette colonne du capteur, que l'interrupteur supplémentaire (TV1), relié au conducteur de colonne (SP1) de la première colonne et qui est normalement toujours conducteur, est ouvert uniquement pendant la durée de l'état de conduction du transistor de sélection de colonne (ST1), que le signal de capteur du premier élément capteur (D11) est transmis à la sortie (A) du capteur et que ce processus de lecture est effectué séquentiellement pour tous les éléments capteurs de la ligne à lire et ensuite, de façon analogue, pour les autres lignes du capteur.

6. Procédé pour la mise en œuvre d'un capteur d'images à semi-conducteurs selon la revendication 3, caractérisé en ce que le conducteur de ligne (L1) d'une ligne à lire du capteur est sélecté à travers une sortie parallèle (A1) du registre à décalage vertical (VSR), mais avec maintien à l'état bloqué du transistor de sélection de ligne (TZ1) coordonné, que le conducteur de sélection de colonne (SPA1) de la première colonne du capteur est alimenté, à travers une sortie parallèle (B1) du registre à décalage horizontal (HSR), avec une tension qui rend conducteur le transistor de sélection de colonne (ST1) correspondant et les seconds transistors de sélection (T11') des éléments capteurs (D11) de cette colonne, que l'interrupteur supplémentaire, relié au conducteur de colonne (SP1) de la première colonne et qui est normalement toujours conducteur, s'ouvre uniquement pendant la durée de l'état de conduction du transistor de sélection de colonne (ST1), que les fractions de tension du bruit, présentes sur le conducteur de colonne (SP1) et le conducteur de lecture (AL), de même que les injections de tensions parasites provoquées par l'actionnement des transistors de commutation, sont mémorisées à travers le transistor de sélection de colonne (ST1), rendu conducteur, dans l'étage de formation de différence (CDS), avec un premier signe, que le transistor de sélection de ligne (TZ1) du conducteur de ligne sélecté est ensuite rendu conducteur, de sorte que les premiers transistors de sélection (T11) de la ligne concernée du capteur sont rendus conducteurs, que le signal de capteur du premier élément capteur (D11) de cette ligne, y compris les fractions de tension de bruit et les injections de tensions parasites mentionnées, est superposé, dans l'étage de formation de différence (CDS), au signal précédemment mémorisé, mais avec un second signe, que le signal de différence ainsi produit est transmis à la sortie (A') du capteur et que ce processus de lecture est effectué séquentiellement pour tous les éléments capteurs de la ligne sélectée et ensuite, de façon analogue, pour les autres lignes du capteur.

7. Procédé selon la revendication 5 ou 6, caractérisé en ce que, avant l'application au conducteur de sélection de colonne (SPA1) de la tension apparaissant sur la sortie parallèle (B1) du registre à décalage horizontal (HSR), les conducteurs de lignes (L1...Lz) sont ramenés au potentiel de base (3) et le conducteur de lecture (AL) est ramené à un potentiel de référence.

# FIG 1

EP 0 107 073 B1

# FIG 2

# FIG 3

FIG 4

EP 0 107 073 B1